# EUROPÄISCHE PATENTSCHRIFT

(11) **EP 3 014 658 B1**
(45) Veröffentlichungstag und Bekanntmachung des Hinweises auf die Patenterteilung: **20.03.2024**
(21) Anmeldenummer: 14739705.3
(22) Anmeldetag: 25.06.2014
(51) Int. Cl.: H01L 29/78, H01L 29/786

(54) **FELDEFFEKTTRANSISTOR-ANORDNUNG**
FIELD EFFECT TRANSISTOR ARRANGEMENT
SYSTÈME DE TRANSISTOR À EFFET DE CHAMP

(30) Priorität: 26.06.2013 DE 102013106729
(43) Veröffentlichungstag der Anmeldung: 04.05.2016
(73) Patentinhaber: Technische Universität Darmstadt, 64289 Darmstadt (DE)
(72) Erfinder: SCHWALKE, Udo, 64839 Münster (DE); WESSELY, Frank, 64807 Dieburg (DE); KRAUSS, Tillmann, 63150 Heusenstamm (DE)
(74) Vertreter: Habermann Intellectual Property Partnerschaft von Patentanwälten mbB
(86) Internationale Anmeldenummer: PCT/EP2014/063459
(87) Internationale Veröffentlichungsnummer: WO 2014/207078

(56) Entgegenhaltungen:
- US-A1- 2002 009 833
- US-A1- 2004 026 688
- US-A1- 2009 286 363
- US-A1- 2010 065 887
- AKIO SHIMA ET AL: "Metal Schottky Source/Drain Technology for Ultrathin Silicon-on-Thin-Box Metal Oxide Semiconductor Field Effect Transistors", JAPANESE JOURNAL OF APPLIED PHYSICS, JAPAN SOCIETY OF APPLIED PHYSICS, JP, Bd. 50, Nr. 4.2, 1. April 2011 (2011-04-01), Seiten 4DC06-1, XP001573543, ISSN: 0021-4922, DOI: 10.1143/JJAP.50.04DC06 [gefunden am 2011-04-20]
- APPENZELLER J ET AL: "Dual-gate silicon nanowire transistors with nickel silicide contacts", ELECTRON DEVICES MEETING, 2006. IEDM '06. INTERNATIONAL, IEEE, PI, 1. Dezember 2006 (2006-12-01), Seiten 1-4, XP031078255, DOI: 10.1109/IEDM.2006.346842 ISBN: 978-1-4244-0438-4
- FRANK WESSELY ET AL: "Dopant-independent and voltage-selectable silicon-nanowire-CMOS technology for reconfigurable logic applications", SOLID-STATE DEVICE RESEARCH CONFERENCE (ESSDERC), 2010 PROCEEDINGS OF THE EUROPEAN, IEEE, PISCATAWAY, NJ, USA, 14. September 2010 (2010-09-14), Seiten 365-367, XP031787416, ISBN: 978-1-4244-6658-0
- FRANK WESSELY ET AL: "Dopant-free CMOS: A new device concept", DESIGN&TECHNOLOGY OF INTEGRATED SYSTEMS IN NANOSCALE ERA (DTIS), 2012 7TH INTERNATIONAL CONFERENCE ON, IEEE, 16. Mai 2012 (2012-05-16), Seiten 1-3, XP032455168, DOI: 10.1109/DTIS.2012.6232949 ISBN: 978-1-4673-1926-3
- HORNG-CHIH LIN ET AL: "Nano-scale implantless Schottky-barrier SOI FinFETs with excellent ambipolar performance", DEVICE RESEARCH CONFERENCE, 2002. 60TH DRC. CONFERENCE DIGEST JUN 24-26, 2002, PISCATAWAY, NJ, USA,IEEE, 24. Juni 2002 (2002-06-24), Seiten 45-46, XP032408935, DOI: 10.1109/DRC.2002.1029498 ISBN: 978-0-7803-7317-4
- LIN H C ET AL: "A novel implantless MOS thin-film transistor with simple processing, excellent performance and ambipolar operation capability", ELECTRON DEVICES MEETING, 2000. IEDM TECHNICAL DIGEST. INTERNATIONAL DECEMBER 10-13, 2000, PISCATAWAY, NJ, USA,IEEE, 10. Dezember 2000 (2000-12-10), Seiten 857-859, XP032403223, DOI: 10.1109/IEDM.2000.904452 ISBN: 978-0-7803-6438-7

## Beschreibung

Die Erfindung betrifft eine Feldeffekttransistor-Anordnung mit einer planaren Kanalschicht aus einem Halbleitermaterial, die mit einer Unterseite flächig auf einer Oberseite einer elektrisch isolierenden Untergrundschicht aufgebracht ist und auf einer Oberseite von einer elektrisch isolierenden Elektrodenisolierungsschicht bedeckt ist, wobei die planare Kanalschicht eine Dicke von weniger als 100 nm aufweist, während die planare Kanalschicht in den beiden anderen Raumrichtungen jeweils deutlich weiter als 100 nm erstreckt, mit einer Source-Elektrode an einer ersten Seitenkante der Kanalschicht und mit einer Drain-Elektrode an einer zweiten Seitenkante der Kanalschicht, wobei ein Kontaktbereich zwischen der Source-Elektrode und der planaren Kanalschicht sowie ein Kontaktbereich zwischen der Drain-Elektrode und der planaren Kanalschicht) jeweils als eine Midgap-Schottky-Barriere ausgestaltet ist, mit einer über der Kanalschicht zwischen der Source-Elektrode und der Drain-Elektrode angeordneten Steuerelektrode, und mit jeweils einer in der Nähe des Kontaktbereichs der Source-Elektrode und in der Nähe des Kontaktbereichs der Drain-Elektrode angeordneten Barrieresteuerelektrode.

Feldeffekttransistoren bilden die Grundlagen für elektronische Schaltungen, wie sie beispielsweise in integrierten Schaltkreisen bzw. Mikroprozessoren verwendet werden. Auf wenigen Quadratmillimetern wird eine sehr große Anzahl von Feldeffekttransistoren angeordnet und in geeigneter Weise miteinander kontaktiert, um komplexe Schaltungen zu realisieren. Um immer mehr Transistoren auf einer möglichst kleinen Fläche anordnen zu können, werden die Abmessungen eines einzelnen Transistors zunehmend verkleinert und betragen oftmals weniger als 100 nm².

Die Herstellung komplexer Schaltungen mit derart kleinen Transistoren ist aufwändig und fehleranfällig. Für das Verändern von Schaltzuständen einzelner Transistoren wird Energie benötigt, die auch in Wärme umgesetzt wird. Auch ohne eine Veränderung eines Schaltzustands eines Transistors erzeugen die insbesondere bei kleinen Abmessungen kaum vermeidbaren Leckströme einen Energieverlust und Wärme, die abgeführt werden muss, um eine Überhitzung der Feldeffekttransistoren zu vermeiden.

Es sind verschiedene Varianten von Feldeffekttransistoren entwickelt worden, die sich hinsichtlich des konstruktiven Aufbaus und ihrer Eigenschaften Unterscheiden. Die verschiedenen Transistoren können unterschieden werden in p-Kanal-Transistoren, bei denen Defektelektronen als Majoritätsladungsträger eingesetzt werden oder als n-Kanal-Transistoren, bei denen Elektronen als Majoritätsladungsträger eingesetzt werden. In Abhängigkeit von dem jeweiligen Typ des Feldeffekttransistors wird ein geeignet dotiertes Halbleitermaterial für die elektrisch leitende Kanalschicht verwendet, um eine ausreichende, bzw. gegebenenfalls möglichst hohe Konzentration an Majoritätsladungsträgern in der Kanalschicht zur Verfügung zu stellen.

Für die Herstellung integrierter Schaltkreise wird häufig die CMOS-Technologie verwendet. Dabei werden p-Kanal-Feldeffekttransistoren und n-Kanal-Feldeffekttransistoren miteinander vernetzt und so miteinander kombiniert, dass bei einer Anlegung einer Steuerspannung an jeweils zwei komplementären Transistornetzen ein Transistornetz sperrt und das andere leitend ist. Allerdings müssen für die CMOS-Technologie doppelt so viele Transistoren vorgesehen werden, wie für die Realisierung einer entsprechenden Schaltung mit ausschließlich einem Typ von Feldeffekttransistoren beispielsweise in NMOS-Logik erforderlich wäre.

Es sind Feldeffekttransistor-Anordnungen bekannt, deren Eigenschaften, beispielsweise deren Majoritätsladungsträgertyp auch noch nach der Herstellung der Feldeffekttransistor-Anordnung beeinflusst werden kann. Aus der Praxis sind ambipolare Feldeffekttransistoren bekannt, bei denen der für Anwendungen nutzbare Strom des Transistors sowohl durch Elektronen als auch durch Defektelektronen erzeugt und aufrechterhalten werden kann. Aktuelle Entwicklungen in dieser Richtung betreffen beispielsweise FinFETs oder "Nanowire"-Strukturen, bei denen sich der Ladungsträgerkanal im Wesentlichen ausschließlich eindimensional in eine Richtung erstreckt und die Steuerelektrode den Ladungsträgerkanal von möglichst vielen Seiten aus umschließt. Derartige Feldeffekttransistor-Anordnungen sind beispielsweise in Appenzeller et al. "Dual-gate silicon nanowire transistors with nickel silicide contacts" Electron Devices Meeting, 2006. IEDM "06. International, IEEE, Pl, 1. Dezember 2006 (2006-12-01), Seiten 1 - 4, in Frank Wessely et al. "Dopant-independent and voltage-selectable siliconnanowire-CMOS technology for reconfigurable logic applications" Solid-state device research conference (ESSDERC), 2010 Proceedings of the European, IEEE, Piscataway, NJ, USA, 14. September 2010 (2010-09-14), Seiten 365-367 oder in Frank Wessely et al. "Dopant-free CMOS: A new device concept", Design&Technology of integrated systems in nanoscale era (DTIS), 2012 7th international conference on, IEEE, 16. Mai 2012 (2012-05-16), Seiten 1 - 3, beschrieben. Auf Grund der im Wesentlichen eindimensionalen Ausgestaltung des Ladungsträgerkanals und dessen geringen Abmessungen lassen sich schnelle Schaltzeiten und geringe Verlustleistungen bei Schaltvorgängen realisieren. Die Herstellung derartiger Feldeffekttransistor-Anordnungen ist jedoch sehr aufwändig und kostenintensiv.

Auch in den Druckschriften US 2002/009833 A1, in Akio Shima et al. "Metal Schottky Source/Drain Technology for Ultrathin Silcon-on-Thin-Box Metal Ocide Semiconductor Field Effect Transistors" Japanese Journal of Applied Physics, Bd. 50, Nr. 4.2, 1. April 2011 (2011-04-01), Seiten 04DC06-1 - 04DC06-7, in Us 2009/286363 A1 oder in US 2010/065887 A1 sind Feldeffekttransistor-Anordnungen mit im Wesentlichen eindimensional wirkenden Ladungsträgerkanälen beschrieben. Einige der dort beschriebenen Feldeffekttransistor-Anordnungen weisen zwischen der Source-Elektrode und der planaren Kanalschicht sowie zwischen der Drain-Elektrode und der planaren Kanalschicht jeweils einen Kontaktbereich auf, der als eine Midgap-Schottky-Barriere ausgestaltet ist. Die Möglichkeit einer Einflussnahme auf die wesentlichen Eigenschaften der Feldeffekttransistor-Anordnungen wie beispielsweise die Einsatzspannung, bzw. der Beginn des Einschaltens, die Transkonduktanz oder die Charakteristik des Kapazitäts-Spannungsverlaufs sind beschränkt.

Es wird deshalb als eine Aufgabe der vorliegenden Erfindung angesehen, eine Feldeffekttransistor-Anordnung der eingangs genannten Gattung so auszugestalten, dass die Feldeffekttransistor-Anordnung möglichst vorteilhafte Eigenschaften aufweist und gleichzeitig kostengünstig hergestellt werden kann.

Diese Aufgabe wird erfindungsgemäß dadurch gelöst, dass die planare Kanalschicht aus einem nicht dotierten Halbleitermaterial besteht, dass an einer Unterseite der Untergrundschicht eine Einstellelektrode angeordnet ist, und dass die Barrieresteuerelektrode jeweils zwischen der Steuerelektrode und der Source-Elektrode bzw. der Steuerelektrode und der Drain-Elektrode separat von der Steuerelektrode elektrisch leitend kontaktierbar angeordnet ist. Eine derartige Feldeffekttransistor-Anordnung kann mit wenigen Verfahrensschritten in der bereits vielfach praxiserprobten und kostengünstigen Silizium-Technologie hergestellt werden. Der Ladungsträgerkanal wird wie bei aus der Praxis bekannten MIS-FETs oder MOS-FETs als planare Struktur ausgebildet, deren Dicke wesentlich geringer als ihre Erstreckung in den anderen beiden Raumrichtungen ist, die mit der Hauptebene der elektrisch isolierenden Untergrundschicht zusammenfallen, auf der die planare Kanalschicht angeordnet ist.

Die planare Kanalschicht weist eine Dicke von weniger als 100 nm oder sogar von weniger 20 nm aufweisen, während sich die planare Kanalschicht in den beiden anderen Raumrichtungen jeweils deutlich weiter als 100 nm erstreckt und beispielsweise Abmessungen von 200 x 200 nm oder 400 x 400 nm aufweist.

Die planare Kanalschicht besteht aus einem nicht dotierten Halbleitermaterial. Durch die Vorgabe eines elektrischen Potenzials über die Einstellelektrode an der Unterseite der Untergrundschicht kann erreicht werden, dass sich innerhalb der Kanalschicht Majoritätsladungsträger ansammeln, deren Ladungstyp bzw. Polarität durch ein an der Einstellelektrode angelegtes elektrisches Potenzial vorgegeben werden kann. Wird beispielsweise ein negatives Potenzial von einigen Volt an der Einstellelektrode erzeugt, bilden sich in der planaren Kanalschicht Elektronenfehlstellen bzw. Defektelektronen oder Löcher aus, die als Majoritätsladungsträger einen Stromfluss zwischen der Source-Elektrode und der Drain-Elektrode ermöglichen. Wird dagegen an der Einstellelektrode ein positives Potenzial von mehreren Volt angelegt, so werden Elektronen in der planaren Kanalschicht angereichert, die als Majoritätsladungsträger einen Stromfluss zwischen der Source-Elektrode und der Drain-Elektrode ermöglichen.

Untersuchungen haben gezeigt, dass die Konzentration der Majoritätsladungsträger in der planaren Kanalschicht im Bereich einer Grenzfläche zu der Untergrundschicht an der Unterseite der planaren Kanalschicht am größten ist, da dieser Bereich am stärksten durch das elektrische Potenzial von der Einstellelektrode beeinflusst werden kann. Obwohl die Majoritätsladungsträger einen Leitungskanal innerhalb der planaren Kanalschicht bilden, der räumlich in einem von der Steuerelektrode abgewandten Bereich verläuft, ist es bei einer geeigneten Ausgestaltung und Ansteuerung der Steuerelektrode in Verbindung mit einer ausreichend geringen Dicke der planaren Kanalschicht möglich, den durch eine Potenzialdifferenz zwischen der Source-Elektrode und der Drain-Elektrode durch die planare Kanalschicht hindurch ermöglichten Stromfluss an der Unterseite der planaren Kanalschicht zu beeinflussen und zu modulieren.

Durch die Ausgestaltung der Kontaktbereiche zwischen der planaren Kanalschicht und der Source-Elektrode bzw. der Drain-Elektrode als Midgap-Schottky-Barriere ist es sowohl Elektronen als auch Elektronenfehlstellen gleichermaßen möglich, beispielsweise durch Feldemission und bei ausreichend hoher Temperatur auch durch thermionische Feldemission die Midgap-Schottky-Barriere zu überwinden und sich in der planaren Kanalschicht anzureichern. Ein geeignetes Material zur Herstellung der Midgap-Schottky-Barriere ist beispielsweise Nickelsilizid. Die Austrittsarbeitsdifferenz des Materials der Kontaktbereiche zwischen der Source-Elektrode, bzw. der Drain-Elektrode und der planaren Kanalschicht wird zweckmäßigerweise so gewählt, dass die Übertrittswahrscheinlichkeit von Elektronen und Defektelektronen durch entsprechende Potentiale an den Steuerelektroden in vergleichbaren Größenordnungen verändert, bzw. erhöht werden kann.

Die Dicke der planaren Kanalschicht muss ausreichend gering vorgegeben sein, um über die Steuerelektrode ein von der Steuerelektrode ausgehendes elektrisches Feld aufbauen zu können, das von der Oberseite der planaren Kanalschicht bis an deren Unterseite reicht, an der die Konzentration der Majoritätsladungsträger am größten ist. Es hat sich gezeigt, dass beispielsweise für eine ausführlich untersuchte Konfiguration einer erfindungsgemäßen Feldeffekttransistor-Anordnung bei einer Dicke der planaren Kanalschicht von etwa 20 nm eine Potenzialdifferenz von 3 Volt (ein elektrisches Potenzial von -1,5 Volt an der Einstellelektrode und ein elektrisches Potenzial von +1,5 Volt an der Steuerelektrode) ausreicht, um eine für eine Stromleitung ausreichende Elektronenfehlstellen-Konzentration im Bereich der Steuerelektrode zu unterbrechen und die Elektronenfehlstellen aus einem Bereich um die Steuerelektrode herum zu verdrängen, so dass die Feldeffekttransistor-Anordnung keinen Stromfluss von der Source-Elektrode zur Drain-Elektrode bei einem Potentialunterschied zwischen diesen von 0,1 Volt zulässt. Der Abstand zwischen der Source-Elektrode und der Drain-Elektrode sollte beispielsweise im Hinblick auf einen wünschenswert niedrigen Kanalwiderstand oder Serienwiderstand oder im Hinblick auf wünschenswert kurze Schaltzeiten möglichst klein vorgegeben werden und beispielsweise geringer als wenige 100 nm, vorzugsweise geringer als 100 nm sein. Die vorangehend genannten Potenzialwerte wurden mit einer Feldeffekttransistor-Anordnung ermittelt und bestätigt, bei der die Isolationsschicht der Steuerelektrode eine Dicke von 10'nm sowie eine relative Permittivität von 8 und die Dicke der Isolationsschicht der Einstellelektrode 20 nm beträgt sowie eine relative Permittivität von 3,9 aufweist. Die Source-Elektrode weist einen Abstand von 500 nm zur Drain-Elektrode auf und die Steuerelektrode weist in dieser Richtung eine Erstreckung von 200 nm auf.

Wird dagegen an der Steuerelektrode ein geringeres positives Potenzial oder ein negatives Potenzial angelegt, bildet sich kein ausreichend starkes elektrisches Feld im Bereich der Steuerelektrode aus, so dass das schwache elektrische Feld die an der Unterseite der planaren Kanalschicht konzentrierten Elektronenfehlstellen nicht vollständig verdrängen kann und ein von den Elektronenfehlstellen gebildeter durchgehender Leitungskanal in der planaren Kanalschicht einen Stromfluss von der Source-Elektrode zur Drain-Elektrode ermöglichen kann.

Erfindungsgemäß ist vorgesehen, dass in der Nähe des Kontaktbereichs der Source-Elektrode und in der Nähe des Kontaktbereichs der Drain-Elektrode jeweils eine Barrieresteuerelektrode angeordnet ist. Durch die Barrieresteuerelektroden kann im Bereich der Midgap-Schottky-Barriere ein elektrisches Potenzial vorgegeben bzw. die Schottky-Barriere mit einem elektrischen Feld überlagert und dadurch die Wahrscheinlichkeit verändert werden, mit der entweder Elektronen oder aber Elektronenfehlstellen die Schottky-Barriere überwinden können. Auf diese Weise kann durch das Anlegen eines geeigneten elektrischen Potenzials an den Barrieresteuerelektroden die Barrierewirkung der Schottky-Barriere für Elektronen herabgesetzt werden, so dass Elektronen durch Feldemission die Schottky-Barriere überwinden können. Wird ein entgegengesetztes elektrisches Potenzial über die Barrieresteuerelektroden erzeugt, werden Elektronenfehlstellen begünstigt, die dann leichter die Schottky-Barriere durchdringen können.

Es ist möglich, sowohl bei der Einstellelektrode als auch bei den Barrieresteuerelektroden ein identisches oder zumindest sehr ähnliches Potenzial vorzugeben, um eine hohe Konzentration der gewünschten Majoritätsladungsträger in der planaren Kanalschicht zu erzeugen. Durch die Vorgabe von voneinander abweichenden elektrischen Potenzialen bzw. elektrischen Spannungen können davon abhängende Eigenschaften der Feldeffekttransistor-Anordnung gezielt beeinflusst werden.

Um die Auswirkungen der Barrieresteuerelektroden auf die zugeordneten Kontaktbereiche bzw. auf die jeweilige Schottky-Barriere zu verstärken ist vorgesehen, dass die Barrieresteuerelektroden jeweils eine in Richtung der planaren Kanalschicht vorspringende Ausformung aufweisen. Durch die vorspringende Ausformung ragen die Barrieresteuerelektroden in die Richtung der seitlich an die planare Kanalschicht angrenzenden Kontaktbereiche der Source-Elektrode und der Drain-Elektrode. Auf Grund des dadurch verringerten Abstands zwischen den Barrieresteuerelektroden und den Schottky-Barrieren wirkt sich ein über die Barrieresteuerelektroden vorgegebenes Potenzial bzw. ein von den Barrieresteuerelektroden verursachtes elektrisches Feld stärker auf die Schottky-Barrieren aus.

Gemäß einer Ausgestaltung des Erfindungsgedankens ist vorgesehen, dass die Untergrundschicht aus einem Dielektrikum besteht und jeweils ein an den Kontaktbereich der Source-Elektrode und an den Kontaktbereich der Drain-Elektrode angrenzender Bereich des Dielektrikums eine erhöhte Permittivität aufweist. Durch die erhöhte Permittivität werden die Auswirkungen des von der Einstellelektrode in der elektrisch isolierenden Untergrundschicht erzeugten elektrischen Feldes auf die Schottky-Barrieren verstärkt. Da die erhöhte Permittivität räumlich auf die an die Schottky-Barrieren angrenzenden Bereiche des Dielektrikums beschränkt ist und das Dielektrikum insbesondere in einem Bereich in der Nähe der Steuerelektrode keine erhöhte Permittivität aufweist, bleibt die Einsatzspannung der Feldeffekttransistor-Anordnung in Abhängigkeit von der Ansteuerung der Steuerelektrode weitestgehend unverändert.

Durch die Anordnung und Formgebung von Barrieresteuerelektroden und durch eine erhöhte Permittivität der ersten elektrisch isolierenden Materialschicht in den an die Schottky-Barriere angrenzenden Bereichen kann jeweils auf den Stromfluss bzw. auf den bei einer vorgegebenen Potenzialdifferenz zwischen der Source-Elektrode und der Drain-Elektrode maximal erzeugbaren Stromfluss Einfluss genommen werden, ohne gleichzeitig andere relevante Eigenschaften der Feldeffekttransistor-Anordnung merklich zu verändern.

Um die Auswirkungen der Steuerelektrode zu verbessern ist einer Ausgestaltung des Erfindungsgedankens zufolge vorgesehen, dass die planare Kanalschicht in einem Bereich um die Steuerelektrode eine geringere Dicke als in angrenzenden Bereichen in einem Abstand zur Steuerelektrode aufweist.

Es ist ebenfalls möglich, dass die Elektrodenisolierungsschicht in einem Bereich um die Steuerelektrode eine geringere Dicke als in angrenzenden Bereichen in einem Abstand zur Steuerelektrode aufweist.

In beiden Fällen wird durch eine geeignete Ausgestaltung der planaren Kanalschicht selbst oder durch eine Ausgestaltung der die planare Kanalschicht von der Steuerelektrode elektrisch isolierenden Elektrodenisolierungsschicht der Abstand der Steuerelektrode zu der Unterseite der planaren Kanalschicht verändert bzw. reduziert. Die über die Einstellelektrode erzeugten Majoritätsladungsträger konzentrieren sich an der Unterseite der planaren Kanalschicht. Je geringer der Abstand der Steuerelektrode zu der Unterseite der planaren Kanalschicht ist, umso stärker wirken sich Potenzialdifferenzen und ein dadurch erzeugtes elektrisches Feld in der Umgebung der Steuerelektrode auf die Majoritätsladungsträger aus.

Einer Ausgestaltung des Erfindungsgedankens zufolge ist vorgesehen, dass die Elektrodenisolierungsschicht eine Ausnehmung für die Steuerelektrode zur direkten Kontaktierung der planaren Kanalschicht mit der Steuerelektrode aufweist und dass die Steuerelektrode als ein Metall-Halbleiterkontakt ausgebildet ist. Auf Grund der direkten Kontaktierung der planaren Kanalschicht mit der Steuerelektrode lassen sich sehr kurze Schaltdauern bzw. hohe Schaltgeschwindigkeiten realisieren. Die Steuerelektrode wirkt unmittelbar auf die planare Kanalschicht und wird nicht durch die Elektrodenisolierungsschicht bzw. durch eine elektrisch isolierende Materialschicht von der Kanalschicht getrennt. Über eine geeignete Vorgabe der für den Metall-Halbleiterkontakt verwendeten Materialien und Materialkombinationen können die Eigenschaften der Feldeffekttransistor-Anordnung beeinflusst werden.

Anstelle einer direkten Kontaktierung der planaren Kanalschicht mit der Steuerelektrode kann auch vorgesehen sein, dass die planare Kanalschicht beabstandete Ausnehmungen für von der Steuerelektrode abstehende, zur Untergrundschicht hin vorspringende Steuerelektrodenschenkel aufweist. Die zur Untergrundschicht hin und gegebenenfalls in die planare Kanalschicht hinein vorspringenden Steuerelektrodenschenkel können einen zwischen den vorspringenden Steuerelektrodenschenkeln befindlichen Bereich der planaren Kanalschicht seitlich umgreifen. Dieser zwischen jeweils zwei vorspringenden Steuerelektrodenschenkeln befindliche Bereich der planaren Kanalschicht wird dann nahezu vollständig auf drei Seiten von der Steuerelektrode und den zugeordneten Steuerelektrodenschenkeln umgeben, so dass ein durch die Steuerelektrode erzeugtes elektrisches Feld über drei Seitenflächen auf dieses Kanalgebiet einwirkt, wodurch eine merklich verbesserte Ansteuerung der Feldeffekttransistor-Anordnung ermöglicht wird. Zudem können die Steuerelektrodenschenkel ein elektrisches Feld erzeugen, welches dem elektrischen Feld der Einstellelektrode überlagert ist und dessen Einfluss auf die planare Kanalschicht zumindest teilweise kompensiert, wodurch die Leitfähigkeit des durch die Einstellelektrode erzeugten Leitungskanals ebenfalls sehr direkt und schnell beeinflusst werden kann. Die derart verstärkte Modulationswirkung der Steuerelektrode eignet sich in besonderer Weise für Hochtemperaturanwendungen der Feldeffekttransistor-Anordnung.

Die Steuerelektrode kann zwei verschiedene Metalle oder Metallschichtsysteme mit unterschiedlichen Austrittsarbeiten aufweisen, wobei jedes Metall einen direkten Kontakt zur isolierenden Schicht in Richtung des planaren Kanalschicht haben muss. Durch die Kombination von zwei Metallen mit unterschiedlicher Austrittsarbeit kann auf die Potenzialdifferenzen zwischen der Steuerelektrode und der Einstellelektrode Einfluss genommen werden, die in Abhängigkeit von den durch die Einstellelektrode vorgegebenen Majoritätsladungsträgern für die Erzeugung oder die Blockade eines Stromflusses von der Source-Elektrode zur Drain-Elektrode erforderlich sind. Dadurch können unerwünschte Verlustleistungen in CMOS-Schaltungen reduziert werden, die mit der erfindungsgemäßen Feldeffekttransistor-Anordnung realisiert werden.

Die Feldeffekttransistor-Anordnung kann zweckmäßigerweise in Anwendung der aus der Praxis bekannten SOI-Technik hergestellt werden, wobei eine sehr dünne Siliziumschicht auf einem Trägersubstrat auf einer elektrisch isolierenden Materialschicht angeordnet wird. Die erfindungsgemäße Feldeffekttransistor-Anordnung benötigt keine Dotierung des Halbleitermaterials bzw. der planaren Kanalschicht, obwohl eine Dotierung in Einzelfällen vorgesehen und gegebenenfalls zweckmäßig sein kann. Die für eine Modulation des Stromflusses erforderliche bzw. charakteristische Potenzialdifferenz kann in vorteilhafter Weise durch eine Dotierung der Untergrundschicht beeinflusst werden. Beispielsweise kann durch eine Dotierung der Untergrundschicht mit Phosphor oder mit Bor der Betrag der an der Steuerelektrode erforderlichen Schaltspannung auf deutlich weniger als 1 Volt reduziert werden.

Erfindungsgemäß können komplexe Schaltungen in einfacher Weise und kostengünstig dadurch hergestellt werden, dass mehrere planare Kanalschichten aus einem Halbleitermaterial mit jeweils zugeordneten Source-Elektroden, Drain-Elektroden, Steuerelektroden und Einstellelektroden nebeneinander auf einem gemeinsamen Trägersubstrat angeordnet und durch vertikale Gräben oder Isolierungen voneinander getrennt sind. Mit einer derartigen Anordnung einer großen Anzahl von Feldeffekttransistoren mit den vorangehend beschriebenen Merkmalen und Eigenschaften lassen sich beispielsweise auch rekonfigurierbare Schaltungen realisieren, bei denen ein geringer Raumbedarf mit kurzen Schaltzeiten und geringen Verlustleistungen kombiniert werden können. Jede planare Kanalschicht kann in Abhängigkeit von der Ansteuerung der zugeordneten Einstellelektrode mit Elektronen oder aber mit Elektronenfehlstellen als Majoritätsladungsträgern angereichert und dementsprechend als n-Kanal-Transistor oder als p-Kanal-Transistor eingesetzt werden. Es ist nicht notwendig, bereits bei der Herstellung komplexer Schaltungen jeweils ortsfeste n-Kanal-Transistoren und p-Kanal-Transistoren vorzusehen.

Nachfolgend werden Ausführungsbeispiele des Erfindungsgedankens näher erläutert, die in der Zeichnung dargestellt sind. Es zeigt:
Fig. 1 eine schematische Schnittansicht einer erfindungsgemäßen Feldeffekttransistor-Anordnung mit einer planaren Kanalschicht aus einem Halbleitermaterial, mit einer Source-Elektrode mit einer Drain-Elektrode und mit einer Steuerelektrode sowie mit einer auf einer gegenüberliegenden Seite der planaren Kanalschicht angeordneten Einstellelektrode.
Fig. 2 eine schematische Draufsicht auf die in Fig. 1 abgebildete Feldeffekttransistor-Anordnung,
Fig. 3 eine schematische Darstellung eines Energieband-Diagramms für die planare Kanalschicht in einem SperrZustand der Feldeffekttransistor-Anordnung, in der Elektronenfehlstellen angereichert wurden,
Fig. 4 eine schematische Darstellung eines Energieband-Diagramms gemäß Fig. 3, wobei in der planaren Kanalschicht Elektronen angereichert wurden,
Fig. 5 ein simuliertes Eingangskennlinienverhalten bei einer gemeinsamen Ansteuerung bzw. einheitlichen Vorgabe des Potenzials der Einstellelektrode und der Barrieresteuerelektroden,
Fig. 6 ein simuliertes Eingangskennlinienverhalten in Abhängigkeit von der Ansteuerung der Steuerelektrode für verschiedene Arbeitspunkte, die durch die Ansteuerung der Einstellelektrode und der Barrieresteuerelektroden vorgegeben sind,
Fig. 7 eine schematische Schnittansicht einer Feldeffekttransistor-Anordnung gemäß Fig. 1, wobei die Barrieresteuerelektroden eine abweichende Formgebung aufweisen,
Fig. 8 eine schematische Schnittansicht einer Feldeffekttransistor-Anordnung, bei der die Untergrundschicht Bereiche mit unterschiedlicher Permittivität aufweist,
Fig. 9 eine schematische Schnittansicht einer Feldeffekttransistor-Anordnung mit einer zu einer Unterseite der planaren Kanalschicht verlagerten Steuerelektrode,
Fig. 10 eine schematische Schnittansicht einer Feldeffekttransistor-Anordnung, bei der die Steuerelektrode aus zwei verschiedenen Metallen bzw. Metallschichtsystemen besteht,
Fig. 11 eine schematische Schnittansicht einer Feldeffekttransistor-Anordnung, bei der die Steuerelektrode direkt mit der planaren Kanalschicht kontaktiert ist,
Fig. 12 eine schematische Schnittansicht einer Feldeffekttransistor-Anordnung, bei der mehrere planare Kanalschichten mit jeweils zugeordneten Source-Elektroden, Drain-Elektroden, Steuerelektroden und Einstell-Elektroden auf einem gemeinsamen Trägersubstrat angeordnet und durch eine vertikale Isolierungsschicht voneinander getrennt sind, und
Fig. 13 eine schematische Schnittansicht einer Feldeffekttransistor-Anordnung, die weitgehend der in Fig. 12 dargestellten Feldeffekttransistor-Anordnung entspricht, wobei an Stelle der horizontalen Isolierungsschicht eine ebenfalls elektrisch isolierende Schichtabfolge von abwechselnd p-dotierem und n-dotiertem Halbleitermaterial angeordnet ist.

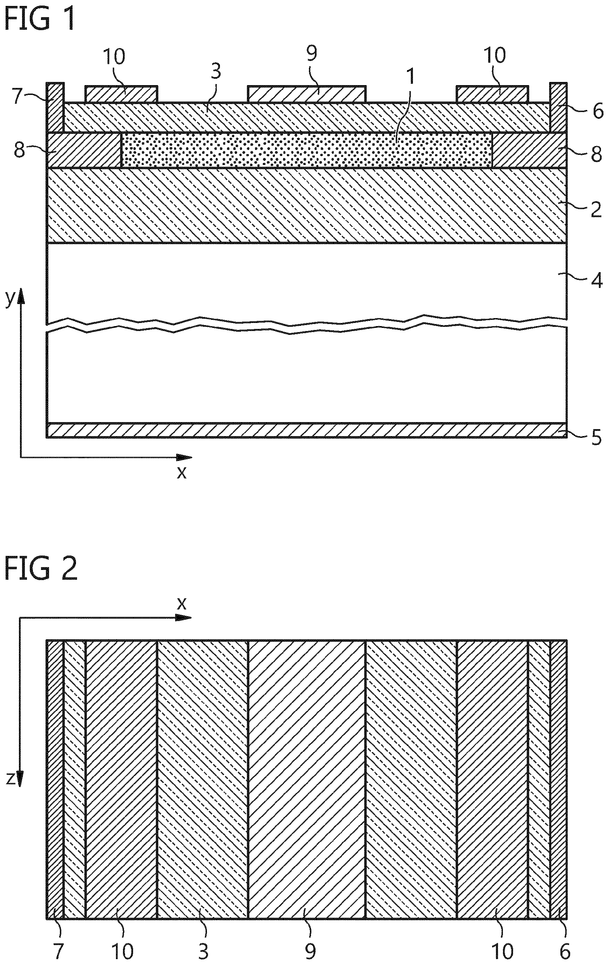

Eine in den Fig. 1 und 2 schematisch dargestellte Feldeffekttransistor-Anordnung weist eine planare Kanalschicht 1 aus einem nicht dotierten Siliziummaterial auf. Die planare Kanalschicht 1 ist auf einer Oberseite einer elektrisch isolierenden Untergrundschicht 2 angeordnet, die aus Siliziumoxid besteht. Die planare Kanalschicht 1 ist von einer elektrisch isolierenden Elektrodenisolierungsschicht 3 bedeckt, die ebenfalls aus Siliziumoxid besteht. Unter der Untergrundschicht 2 sind ein Trägersubstrat 4 und an dessen Unterseite vollflächig eine elektrisch leitend kontaktierbare Einstellelektrode 5 angeordnet.

An zwei gegenüberliegenden Seitenkanten der planaren Kanalschicht 1 sind eine elektrisch leitend kontaktierbare Source-Elektrode 6 und eine Drain-Elektrode 7 angeordnet, die durch die Elektrodenisolierungsschicht 3 hindurch jeweils bis in einen seitlich an die planare Kanalschicht angrenzenden Kontaktbereich 8 ragen. Der Kontaktbereich 8 ist als Midgap-Schottky-Barriere ausgestaltet und aus Nickelsilizid hergestellt.

An einer Oberseite der Elektrodenisolierungsschicht 3 ist zwischen der Source-Elektrode 6 und der Drain-Elektrode 7 eine ebenfalls elektrisch leitend kontaktierbare Steuerelektrode 9 angeordnet. Jeweils zwischen der Steuerelektrode 9 und der Source-Elektrode 6 bzw. der Steuerelektrode 9 und der Drain-Elektrode 7 ist eine separat von der Steuerelektrode 9 elektrisch leitend kontaktierbare Barrieresteuerelektrode 10 angeordnet.

Die planare Kanalschicht 1 weist eine Dicke (in den Figuren 1 und 2 in y-Richtung dargestellt) von etwa 20 nm sowie eine Erstreckung von jeweils etwa 400 nm in den beiden anderen Raumrichtungen (in den Figuren 1 und 2 als x-Richtung und z-Richtung dargestellt) auf. Die Source-Elektrode 6, die Drain-Elektrode 7, die Steuerelektrode 9 und die beiden Barrieresteuerelektroden 10 weisen eine streifenförmige Formgebung auf und erstrecken sich jeweils parallel verlaufend in einer Richtung (in den Figuren 1 und 2 als z-Richtung dargestellt) im Wesentlichen vollständig über die Länge der planaren Kanalschicht 1. Dementsprechend erstrecken sich auch die Kontaktbereiche zwischen der Source-Elektrode 6, bzw. der Drain-Elektrode 7 und der dazwischen befindlichen planaren Kanalschicht 1 im Wesentlichen über die gesamte Länge der planaren Kanalschicht 1.

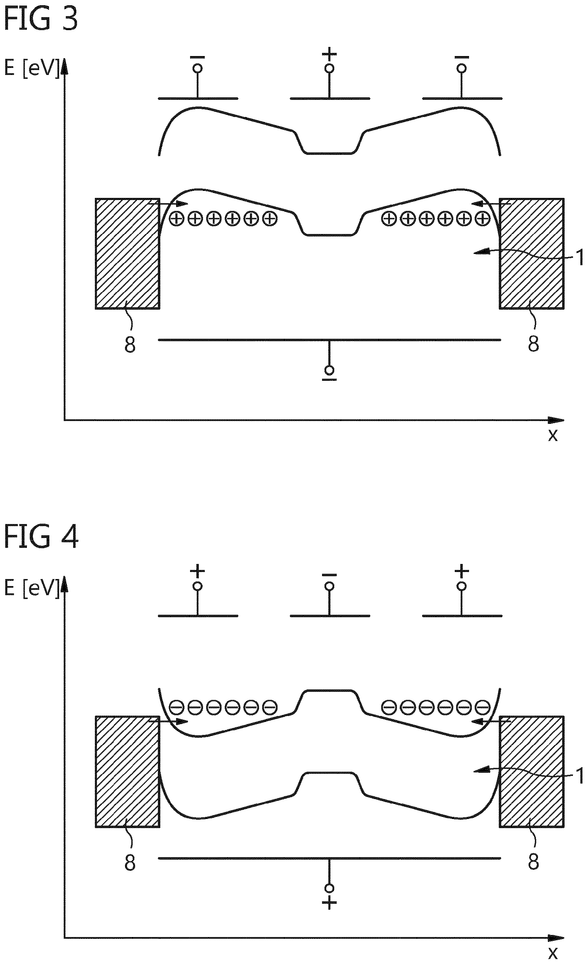

In den Figuren 3 und 4 ist schematisch der Verlauf der Energiebänder in dem Halbleitermaterial der planaren Kanalschicht 1 dargestellt, wobei unterschiedliche Potenzialdifferenzen zwischen einerseits der Einstellelektrode 5 und den beiden Barrieresteuerelektroden 10 und andererseits der Steuerelektrode 9 vorgegeben sind.

Bei dem in Figur 3 gezeigten Ausführungsbeispiel ist an der Einstellelektrode 5 und den beiden Barrieresteuerelektroden 10 jeweils ein negatives elektrisches Potenzial von etwa -10 Volt angelegt, während an der Steuerelektrode 9 ein positives elektrisches Potenzial von etwa +2 Volt anliegt. Durch das von der Einstellelektrode 5 und den beiden Barrieresteuerelektroden 10 erzeugte elektrische Feld werden Elektronenfehlstellen in der planaren Kanalschicht 1 angereichert, welche die Majoritätsladungsträger in der planaren Kanalschicht 1 darstellen. Die Elektrodenfehlstellen konzentrieren sich hauptsächlich an einer der Untergrundschicht 2 zugewandten Unterseite der planaren Kanalschicht 1 und bilden einen Leitungskanal, der einen Stromfluss zwischen der Source-Elektrode 6 und der Drain-Elektrode 7 ermöglichen kann. Je größer das negative elektrische Potenzial der Einstellelektrode 5 und der Barrieresteuerelektroden 10 ist, umso größer ist die Konzentration der Elektrodenfehlstellen und damit der maximal mögliche Stromfluss durch die planare Kanalschicht 1.

Gleichzeitig werden durch das von der Steuerelektrode 9 erzeugte elektrische Feld in einem Bereich um die Steuerelektrode 9 herum die Elektronenfehlstellen verdrängt. Durch die auf einem positiven Potenzial befindliche Steuerelektrode 9 wird in der planaren Kanalschicht 1 in einer Umgebung um die Steuerelektrode 9 herum ein elektrisches Feld erzeugt, welches den durch die Elektronenfehlstellen ermöglichten Stromfluss moduliert und - bei einem ausreichend starken elektrischen Feld - nahezu vollständig unterbrechen kann.

Bei dem in Figur 4 dargestellten Ausführungsbeispiel ist an der Einstellelektrode 5 und den beiden Barrieresteuerelektroden 10 jeweils ein positives elektrisches Potenzial von etwa +10 Volt angelegt, während an der Steuerelektrode 9 ein negatives elektrisches Potenzial von etwa -2 Volt anliegt. In der planaren Kanalschicht 1 reichern sich Elektronen als Majoritätsladungsträger an und bilden an der Unterseite der planaren Kanalschicht 1 einen Leitungskanal, der durch das elektrische Feld der Steuerelektrode 9 unterbrochen wird.

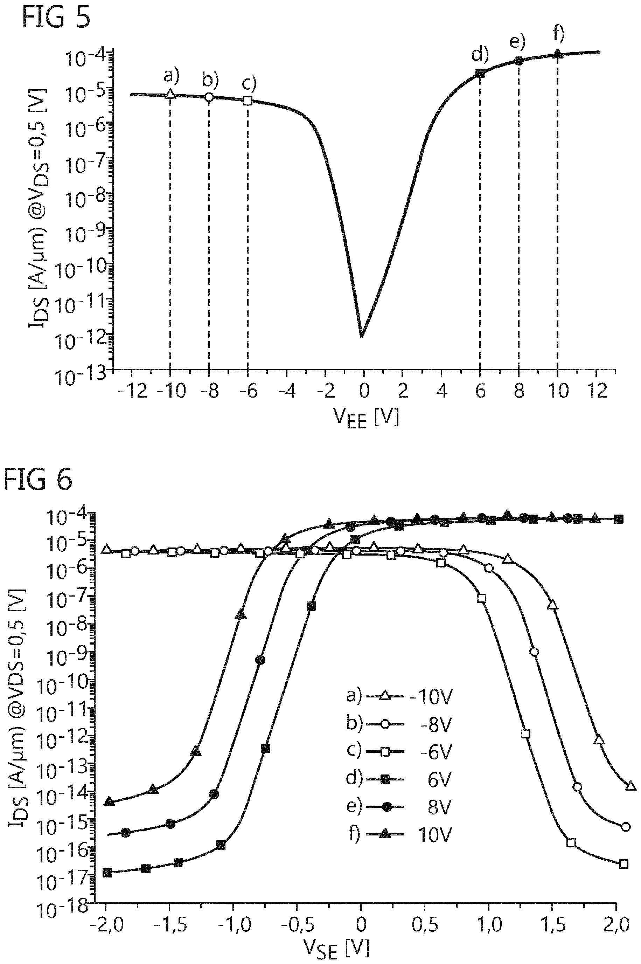

In Figur 5 ist zur Veranschaulichung ein simuliertes Eingangskennlinienverhalten für die vorangehend beschriebene Feldeffekttransistor-Anordnung dargestellt. An der Einstellelektrode 5 und den beiden Barrieresteuerelektroden 10 ist entweder ein negatives elektrisches Potenzial (Potenzialwerten a), b) und c)) oder ein positives elektrisches Potenzial (Potenzialwerte d), e) und f)) vorgegeben. Der in Abhängigkeit von dem vorgegebenen elektrischen Potenzial berechnete Stromfluss I_{DS} ist für eine ebenfalls vorgegebene Spannung V_{DS} von 0,5 Volt zwischen der Source-Elektrode 6 und der Drain-Elektrode 7 dargestellt. Übersteigt der Betrag der anliegenden elektrischen Spannung V_{EE} einige Volt, findet sowohl bei negativem als auch bei positivem Potenzial an der Einstellelektrode 5 und den beiden Barrieresteuerelektroden 10 ein ganz erheblicher Stromfluss durch die planare Kanalschicht 1 statt. Dies zeigt, dass durch das Anlegen einer positiven oder negativen Spannung an der Einstellelektrode 5 Majoritätsladungsträger mit unterschiedlicher Polarität in der planaren Kanalschicht 1 angereichert werden, jedoch in beiden Fällen ein durch die Steuerelektrode 9 modulierbarer Stromfluss zwischen der Source-Elektrode 6 und der Drain-Elektrode 7 ermöglicht werden kann.

In Figur 6 sind für die in Figur 5 hervorgehobenen Potenzialwerte a) bis f), bzw. -10 Volt bis +10 Volt an der Einstellelektrode 5 und den beiden Barrieresteuerelektroden 10 ebenfalls simulierte Verläufe des Stromflusses I_{DS} in Abhängigkeit von einer an der Steuerelektrode 9 angelegten Steuerspannung V_{SE} in einem Bereich von -2 Volt bis +2 Volt dargestellt. Während sich die grundlegende Abhängigkeit des Stromflusses I_{DS} von der Steuerspannung V_{SE} nicht nennenswert unterscheidet, findet für die verschiedenen Potenzialwerte a) bis f) der Wechsel zwischen dem nichtleitenden Zustand zum leitenden Zustand in der planaren Kanalschicht 1 bei geringfügig verschiedenen Werten für die Steuerspannungen V_{SE} statt.

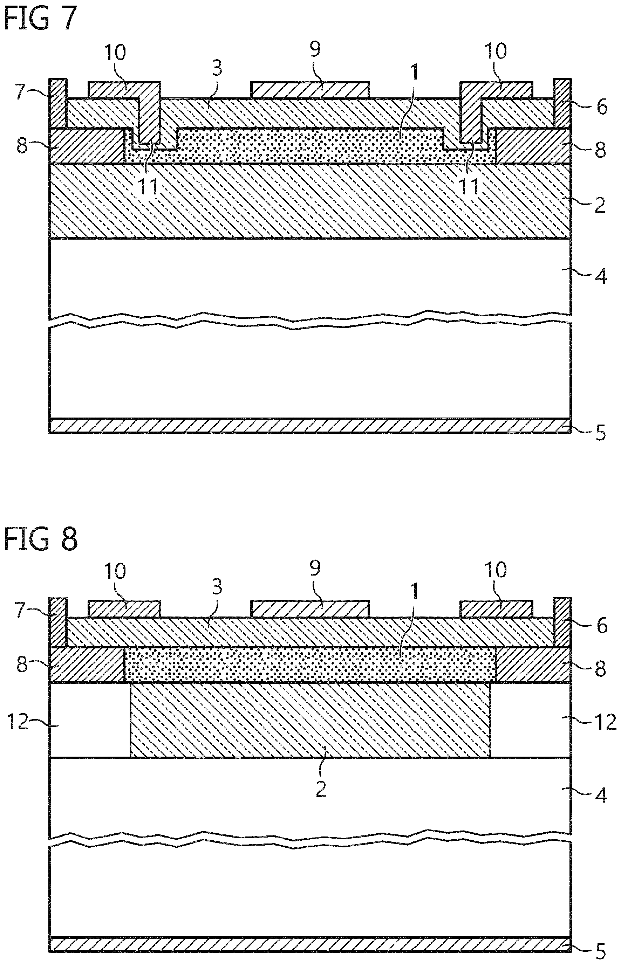

Bei einer abweichend ausgestalteten Feldeffekttransistor-Anordnung gemäß Figur 7 weisen die Barrieresteuerelektroden 10 jeweils eine in Richtung der planaren Kanalschicht 1 vorspringende Ausformungen 11 auf, die sich über die gesamte Länge der streifenförmigen Barrieresteuerelektroden 10 erstrecken. Die vorspringenden Ausformungen 11 ragen bis in die Nähe der Kontaktbereiche 8 und weisen nur einen geringen seitlichen Abstand zu den Kontaktbereichen 8 auf. Das mit den Barrieresteuerelektroden 10 erzeugbare elektrische Feld wirkt auf Grund des geringen Abstands und der großflächigen Annäherung wesentlich stärker auf die Kontaktbereiche 8 bzw. auf die dort gebildeten Schottky-Barrieren ein als die in den Figuren 1 und 2 gezeigten flachen Barrieresteuerelektroden 10 bei einem anliegenden elektrischen Potenzial in vergleichbarer Höhe.

In Figur 8 ist schematisch eine wiederum abweichend ausgestaltete Feldeffekttransistor-Anordnung dargestellt, bei der in der Untergrundschicht 2 in zwei Bereichen 12, die an die Kontaktbereiche 8 der Source-Elektrode 6 und der Drain-Elektrode 7 angrenzen, eine erhöhte Permittivität vorhanden. Das durch die Einstellelektrode 5 an der Unterseite der Untergrundschicht 2 erzeugte elektrische Feld wirkt sich deshalb stärker auf die Kontaktbereiche 8 aus als auf einen mittleren Bereich der planaren Kanalschicht 1 zwischen den beiden Kontaktbereichen 8 und insbesondere unterhalb der Steuerelektrode 9.

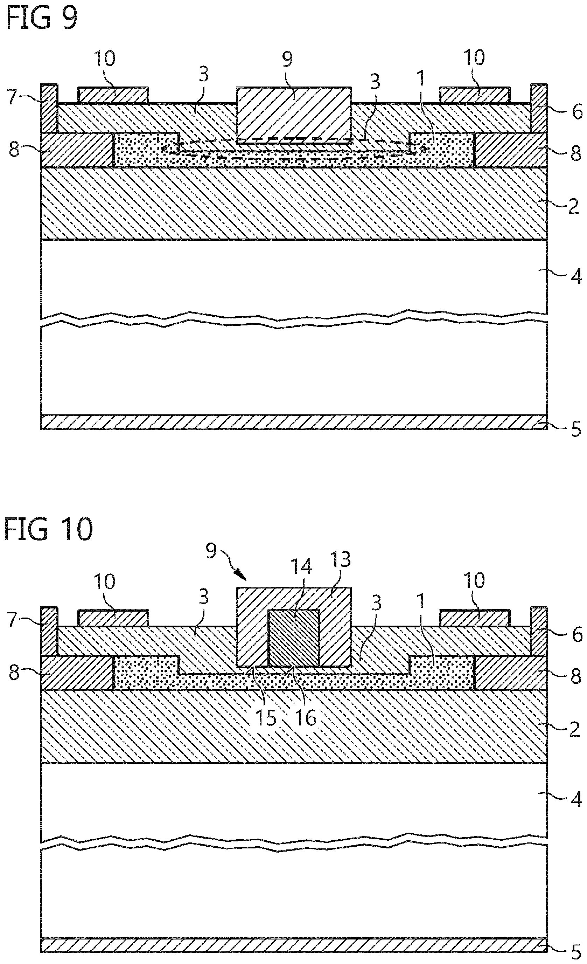

Der Abstand zwischen der Steuerelektrode 9 und der der Steuerelektrode 9 abgewandten Unterseite der planaren Kanalschicht 1 ist bei dem in Figur 9 schematisch dargestellten Ausführungsbeispiel im Vergleich zu den vorangehend beschriebenen Feldeffekttransistor-Anordnungen reduziert und geringer. Dadurch können geringere Steuerspannungen an der Steuerelektrode 9 sowie kürzere Schaltzeiten realisiert werden, um den Stromfluss zu modulieren und freizugeben oder vollständig zu unterbrechen.

Gemäß dem in Fig. 10 exemplarisch dargestellten Ausführungsbeispiel kann die Steuerelektrode 9 aus zwei Bereichen 13 und 14 aus verschiedenen Metallen bzw. aus einem Metallschichtsystem bestehen. Die beiden Bereiche 13 und 14 sind voneinander getrennt, jedoch aneinander angrenzend jeweils mit einer Stirnfläche 15, 16 in Richtung der planaren Kanalschicht 1 angeordnet und in direktem Kontakt mit der elektrisch isolierenden Elektrodenisolierungsschicht 3, welche die Steuerelektrode 9 von der planaren Kanalschicht 1 trennt. Durch die Wahl und Vorgabe der relevanten elektrischen Eigenschaften der in den beiden Bereichen 13 und 14 bzw. in dem Metallschichtsystem angeordneten Metalle können die Schalteigenschaften der Steuerelektrode 9 vorteilhaft beeinflusst werden. Insbesondere können auch in Abhängigkeit von den Majoritätsladungsträgern die Eingangskennlinien verändert werden und damit die für einen Wechsel des Schaltzustands erforderlichen Potentialwerte.

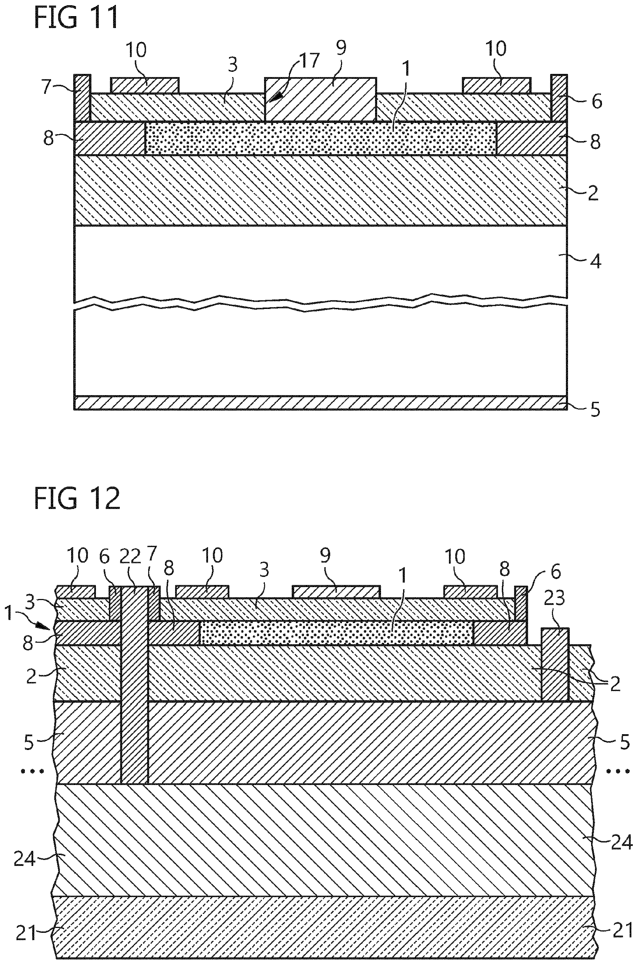

Bei einer in Figur 11 dargestellten Feldeffekttransistor-Anordnung ist die Steuerelektrode 9 in einer Ausnehmung 17 in der Elektrodenisolierungsschicht 3 in einem direkten Kontakt mit der planaren Kanalschicht 1 angeordnet. Die Steuerelektrode 9 ist dabei als Metall-Halbleiter-Kontakt ausgebildet, so dass extrem kurze Schaltzeiten zur Ansteuerung der Feldeffekttransistor-Anordnung mit der Steuerelektrode 9 möglich sind.

Lediglich beispielhaft ist in Figur 12 eine Anordnung von mehreren planaren Kanalschichten 1 aus einem Halbleitermaterial mit jeweils zugeordneten Source-Elektroden 6, Drain-Elektroden 7, Steuerelektroden 9 und Einstellelektroden 5 nebeneinander auf einem gemeinsamen Trägersubstrat 21 angeordnet und durch vertikale Isolierungen 22 voneinander getrennt sind. Jeder planaren Kanalschicht 1 ist eine ebenfalls durch die vertikalen Isolierungen 22 voneinander getrennte Untergrundschicht 2 und eine flächig darunter angeordnete Einstellelektrode 5 zugeordnet, wobei die Einstellelektrode 5 über einen an die Oberseite geführten Einstellelektrodenanschluss 23 elektrisch leitend kontaktiert werden kann. Zwischen dem Trägersubstrat 21 und den Einstellelektroden 5 ist eine zusätzliche horizontale Isolierungsschicht 24 angeordnet. Jede der nebeneinander auf dem gemeinsamen Trägersubstrat 21 angeordneten Feldeffekttransistor-Anordnungen kann durch das Anlegen eines gesonderten Einstellpotenzials und einer gesonderten Steuerspannung unabhängig von der unmittelbar benachbart angeordneten Feldeffekttransistor-Anordnung angesteuert werden.

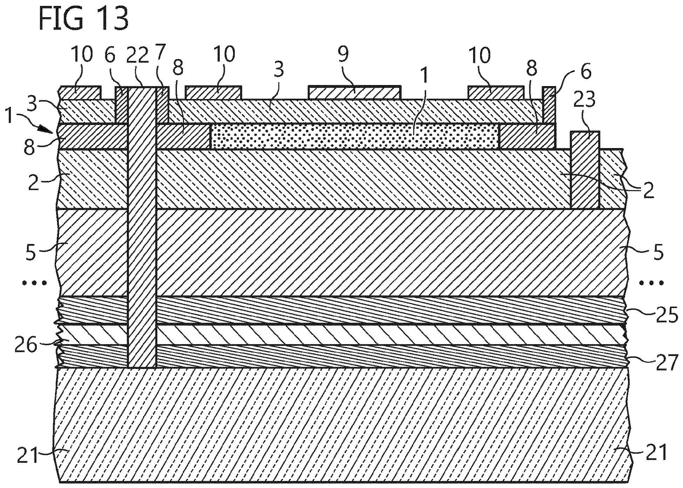

Bei dem in Fig. 13 exemplarisch dargestellten Ausführungsbeispiel ist eine sehr ähnlich zu der in Fig. 12 gezeigten Variante ausgestaltete Feldeffekttransistor-Anordnung dargestellt. An Stelle der horizontalen Isolierungsschicht 24, die beispielsweise aus Siliziumdioxid oder einem anderen in geeigneter Weise elektrisch isolierenden Material bestehen kann, ist bei diesem Ausführungsbeispiel eine Schichtfolge aus unterschiedlich dotiertem Halbleitermaterial angeordnet, die ebenfalls elektrisch isolierend wirkt und einen Stromfluss von den Einstellelektroden 5 zu dem Trägersubstrat 21 unterbindet. Die Schichtfolge besteht in dem dargestellten Ausführungsbeispiel aus einer Abfolge einer p-dotierten Siliziumschicht 25, einer n-dotierten Siliziumschicht 26 und einer p-dotierten Siliziumschicht 27.

## Patentansprüche

1. Feldeffekttransistor-Anordnung mit einer planaren Kanalschicht (1) aus einem Halbleitermaterial, die mit einer Unterseite flächig auf einer Oberseite einer elektrisch isolierenden Untergrundschicht (2) aufgebracht ist und auf einer Oberseite von einer elektrisch isolierenden Elektrodenisolierungsschicht (3) bedeckt ist, wobei die planare Kanalschicht (1) eine Dicke von weniger als 100 nm aufweist, während sich die planare Kanalschicht (1) in den beiden anderen Raumrichtungen jeweils deutlich weiter als 100 nm erstreckt, mit einer Source-Elektrode (6) an einer ersten Seitenkante der Kanalschicht (1) und mit einer Drain-Elektrode (7) an einer zweiten Seitenkante der Kanalschicht (1), wobei ein Kontaktbereich (8) zwischen der Source-Elektrode (6) und der planaren Kanalschicht (1) sowie ein Kontaktbereich (8) zwischen der Drain-Elektrode (7) und der planaren Kanalschicht (1) jeweils als eine Midgap-Schottky-Barriere ausgestaltet ist, mit einer über der Kanalschicht (1) zwischen der Source-Elektrode (6) und der Drain-Elektrode (7) angeordneten Steuerelektrode (9), und mit jeweils einer in der Nähe des Kontaktbereichs (8) der Source-Elektrode (6) und in der Nähe des Kontaktbereichs (8) der Drain-Elektrode (7) angeordneten Barrieresteuerelektrode (10), **dadurch gekennzeichnet, dass** die planare Kanalschicht aus einem nicht dotierten Halbleitermaterial besteht, dass an einer Unterseite der Untergrundschicht (2) eine Einstellelektrode (5) angeordnet ist, und dass die Barrieresteuerelektrode (10) jeweils zwischen der Steuerelektrode (9) und der Source-Elektrode (6) bzw. der Steuerelektrode (9) und der Drain-Elektrode (7) separat von der Steuerelektrode (9) elektrisch leitend kontaktierbar angeordnet ist.

2. Feldeffekttransistor-Anordnung nach Anspruch 1, **dadurch gekennzeichnet, dass** die Barrieresteuerelektroden (10) jeweils eine in Richtung der planaren Kanalschicht (1) vorspringende Ausformung (11) aufweisen.

3. Feldeffekttransistor-Anordnung nach einem der vorausgehenden Ansprüche, **dadurch gekennzeichnet, dass** die elektrisch isolierende Untergrundschicht (2) aus einem Dielektrikum besteht und jeweils ein an den Kontaktbereich (8) der Source-Elektrode (6) und an den Kontaktbereich (8) der Drain-Elektrode (7) angrenzender Bereich (12) des Dielektrikums eine erhöhte Permittivität aufweist.

4. Feldeffekttransistor-Anordnung nach einem der vorausgehenden Ansprüche, **dadurch gekennzeichnet, dass** die planare Kanalschicht (1) in einem Bereich um die Steuerelektrode (9) eine geringere Dicke als in angrenzenden Bereichen in einem Abstand zur Steuerelektrode (9) aufweist.

5. Feldeffekttransistor-Anordnung nach einem der vorausgehenden Ansprüche, **dadurch gekennzeichnet, dass** die Elektrodenisolierungsschicht (3) in einem Bereich um die Steuerelektrode (9) eine geringere Dicke als in angrenzenden Bereichen in einem Abstand zur Steuerelektrode (9) aufweist.

6. Feldeffekttransistor-Anordnung nach einem der vorausgehenden Ansprüche 1 bis 4, **dadurch gekennzeichnet, dass** die Elektrodenisolierungsschicht (3) eine Ausnehmung (13) für die Steuerelektrode (9) zur direkten Kontaktierung der planaren Kanalschicht (1) mit der Steuerelektrode (9) aufweist und dass die Steuerelektrode (9) als ein Metall-Halbleiterkontakt ausgebildet ist.

7. Feldeffekttransistor-Anordnung nach einem der vorausgehenden Ansprüche 1 bis 5, **dadurch gekennzeichnet, dass** die planare Kanalschicht (1) beabstandete Ausnehmungen für von der Steuerelektrode (9) abstehende, zur Untergrundschicht (2) hin vorspringende Steuerelektrodenschenkel aufweist.

8. Feldeffekttransistor-Anordnung nach einem der vorausgehenden Ansprüche, **dadurch gekennzeichnet, dass** die Steuerelektrode (9) zwei verschiedene Metalle mit unterschiedlichen Austrittsarbeiten aufweist.

9. Feldeffekttransistor-Anordnung nach einem der vorausgehenden Ansprüche, **dadurch gekennzeichnet, dass** die Steuerelektrode (9) einen ersten Abstand zu der Source-Elektrode (6) und einen zweiten, von dem ersten Abstand abweichenden Abstand zu der Drain-Elektrode (7) aufweist.

10. Feldeffekttransistor-Anordnung nach einem der vorausgehenden Ansprüche, **dadurch gekennzeichnet, dass** die Einstellelektrode (5) eine Dotierung aufweist.

11. Feldeffekttransistor-Anordnung nach einem der vorausgehenden Ansprüche, **dadurch gekennzeichnet, dass** mehrere planare Kanalschichten (1) aus einem Halbleitermaterial mit jeweils einer zugeordneten Source-Elektrode (6), einer Drain-Elektrode (7), einer Steuerelektrode (9) und einer Einstellelektrode (5) nebeneinander auf einem gemeinsamen Trägersubstrat (21) angeordnet und durch vertikale Gräben oder Isolierungen (22) voneinander getrennt sind.

## Claims

1. Field-effect transistor arrangement having a planar channel layer (1) made of a semiconductor material, the whole surface of an underside of said channel layer being applied to an upper side of an electrically insulating substrate layer (2) and an upper side of said channel layer being covered by an electrically insulating electrode insulation layer (3), wherein the planar channel layer (1) has a thickness of less than 100 nm while the planar channel layer (1) extends much further than 100 nm in each of the two other spatial directions, comprising a source electrode (6) on a first side edge of the channel layer (1) and a drain electrode (7) on a second side edge of the channel layer (1), wherein a contact region (8) between the source electrode (6) and the planar channel layer (1) and a contact region (8) between the drain electrode (7) and the planar channel layer (1) is configured in each case as a midgap Schottky barrier, and comprising a control electrode (9) arranged above the channel layer (1) between the source electrode (6) and the drain electrode (7) and a barrier control electrode (10) arranged, respectively, in the vicinity of the contact region (8) of the source electrode (6) and in the vicinity of the contact region (8) of the drain electrode (7), **characterised in that** the planar channel layer consists of an undoped semiconductor material, an adjusting electrode (5) is arranged on an underside of the substrate layer (2), and the barrier control electrodes (10) are arranged, respectively, between the control electrode (9) and the source electrode (6) and between the control electrode (9) and the drain electrode (7), separately from the control electrode (9), in an electrically conductively contactable manner.

2. Field-effect transistor arrangement according to claim 1, **characterised in that** the barrier control electrodes (10) each have a shape (11) that projects towards the planar channel layer (1).

3. Field-effect transistor arrangement according to one of the preceding claims, **characterised in that** the electrically insulating substrate layer (2) consists of a dielectric, and a region (12) of the dielectric adjoining the contact region (8) of the source electrode (6) and the contact region (8) of the drain electrode (7) respectively has an elevated permittivity.

4. Field-effect transistor arrangement according to one of the preceding claims, **characterised in that** the planar channel layer (1) has a lower thickness in a region around the control electrode (9) than in adjoining regions that are spaced apart from the control electrode (9).

5. Field-effect transistor arrangement according to one of the preceding claims, **characterised in that** the electrode insulation layer (3) has a lower thickness in a region around the control electrode (9) than in adjoining regions that are spaced apart from the control electrode (9).

6. Field-effect transistor arrangement according to one of the preceding claims 1 to 4, **characterised in that** the electrode insulation layer (3) has a recess (13) for the control electrode (9) for directly contacting the planar channel layer (1) with the control electrode (9) and that the control electrode (9) is designed as a metal semiconductor contact.

7. Field-effect transistor arrangement according to one of the preceding claims 1 to 5, **characterised in that** the planar channel layer (1) has spaced recesses for control electrode arms that protrude from the control electrode (9) and project as far as the substrate layer (2).

8. Field-effect transistor arrangement according to one of the preceding claims, **characterised in that** the control electrode (9) has two different metals with different work functions.

9. Field-effect transistor arrangement according to one of the preceding claims, **characterised in that** the control electrode (9) has a first distance from the source electrode (6) and a second distance, different from the first distance, from the drain electrode (7).

10. Field-effect transistor arrangement according to one of the preceding claims, **characterised in that** the adjusting electrode (5) is doped.

11. Field-effect transistor arrangement according to one of the preceding claims, **characterised in that** a plurality of planar channel layers (1), made of a semiconductor material and each having an associated source electrode (6), a drain electrode (7), a control electrode (9) and an adjusting electrode (5), are arranged side by side on a common carrier substrate (21) and are separated from one another by vertical trenches or insulators (22).

## Revendications

1. Système de transistor à effet de champ comportant une couche de canal (1) plane en matériau semi-conducteur qui est appliquée avec une face inférieure à plat sur une face supérieure d'une couche sous-jacente (2) électriquement isolante et qui est recouverte sur une face supérieure d'une couche d'isolation d'électrode (3) électriquement isolante, la couche de canal (1) plane présentant une épaisseur inférieure à 100 nm alors que la couche de canal (1) plane s'étend dans les deux autres directions spatiales respectivement sensiblement sur plus de 100 nm, comportant une source (6) sur un premier bord latéral de la couche de canal (1) et un drain (7) sur un second bord latéral de la couche de canal (1), une zone de contact (8) entre la source (6) et la couche de canal (1) plane ainsi qu'une zone de contact (8) entre le drain (7) et la couche de canal (1) plane étant respectivement réalisées sous la forme d'une barrière de Schottky en milieu de bande interdite, comportant une grille (9) disposée au-dessus de la couche de canal (1) entre la source (6) et le drain (7), et comportant une électrode de commande de barrière (10) respective disposée à proximité de la zone de contact (8) de la source (6) et à proximité de la zone de contact (8) du drain (7), **caractérisé en ce que** la couche de canal plane est constituée d'un matériau semi-conducteur non dopé, **en ce qu'**une électrode de réglage (5) est disposée sur une face inférieure de la couche sous-jacente (2) et **en ce que** l'électrode de commande de barrière (10) est disposée respectivement entre la grille (9) et la source (6) ou la grille (9) et le drain (7), séparément de la grille (9), de façon à pouvoir être amenée en contact de manière électriquement conductrice.

2. Système de transistor à effet de champ selon la revendication 1, **caractérisé en ce que** les électrodes de commande de barrière (10) présentent respectivement une protubérance (11) faisant saillie en direction de la couche de canal (1) plane.

3. Système de transistor à effet de champ selon l'une des revendications précédentes, **caractérisé en ce que** la couche sous-jacente (2) électriquement isolante est constituée d'un diélectrique et une zone (12) respective du diélectrique, adjacente à la zone de contact (8) de la source (6) et à la zone de contact (8) du drain (7), présentant une permittivité plus élevée.

4. Système de transistor à effet de champ selon l'une des revendications précédentes, **caractérisé en ce que** la couche de canal (1) plane présente, dans une zone située autour de la grille (9) une épaisseur inférieure par rapport à des zones adjacentes situées à distance de la grille (9).

5. Système de transistor à effet de champ selon l'une des revendications précédentes, **caractérisé en ce que** la couche d'isolation d'électrode (3) présente, dans une zone située autour de la grille (9) une épaisseur inférieure par rapport à des zones adjacentes situées à distance de la grille (9).

6. Système de transistor à effet de champ selon l'une des revendications précédentes 1 à 4, **caractérisé en ce que** la couche d'isolation d'électrode (3) présente un évidement (13) pour la grille (9) destiné à la mise en contact électrique directe de la couche de canal (1) plane avec la grille (9) et **en ce que** la grille (9) est réalisée sous la forme d'un contact semi-conducteur métallique.

7. Système de transistor à effet de champ selon l'une des revendications précédentes 1 à 5, **caractérisé en ce que** la couche de canal (1) plane présente des évidements espacés pour des branches de grille dépassant vers la couche sous-jacente (2), faisant saillie depuis la grille (9).

8. Système de transistor à effet de champ selon l'une des revendications précédentes, **caractérisé en ce que** la grille (9) présente deux métaux différents avec des travaux de sortie différents.

9. Système de transistor à effet de champ selon l'une des revendications précédentes, **caractérisé en ce que** la grille (9) présente une première distance par rapport à la source (6) et une seconde distance différente de la première distance par rapport au drain (7).

10. Système de transistor à effet de champ selon l'une des revendications précédentes, **caractérisé en ce que** l'électrode de réglage (5) présente un dopage.

11. Système de transistor à effet de champ selon l'une des revendications précédentes, **caractérisé en ce que** plusieurs couches de canal (1) planes en matériau semi-conducteur, dotées respectivement d'une source (6) associée, d'un drain (7), d'une grille (9) et d'une électrode de réglage (5), sont disposées les unes à côté des autres sur un substrat porteur (21) commun et sont séparées les unes des autres par des tranchées ou isolations (22) verticales.
